(19) Europäisches Patentamt
European Patent Office
Office européen des brevets

(11) Publication number: **0 413 863 A1**

## (12) EUROPEAN PATENT APPLICATION

(21) Application number: 89308594.4

(22) Date of filing: 24.08.89

(51) Int. Cl.5: **G03F 3/10**, G03F 7/34

(43) Date of publication of application:
27.02.91 Bulletin 91/09

(84) Designated Contracting States:
DE FR GB

(71) Applicant: TOYO INK MANUFACTURING CO., LTD.
No. 3-13, Kyobashi 2-chome Chuo-ku
Tokyo(JP)

(72) Inventor: Sumita, Masujiro
Toyo Ink Manuf. Co., Ltd. 3-13, Kyobashi 2-chome
Chuo-ku Tokyo(JP)
Inventor: Tsuchiko, Susumu
Toyo Ink Manuf. Co., Ltd. 3-13, Kyobashi 2-chome
Chuo-ku Tokyo(JP)
Inventor: Ohta, Masaru
Toyo Ink Manuf. Co., Ltd. 3-13, Kyiobashi 2-chome
Chuo-ku Tokyo(JP)
Inventor: Hosoi, Isao
Toyo Ink Manuf. Co., Ltd. 3-13, Kyobashi 2-chome
Chuo-ku Tokyo(JP)

(74) Representative: Myerscough, Philip Boyd et al
J.A.Kemp & Co. 14, South Square Gray's Inn
London, WC1R 5EU(GB)

(54) Image-forming process and image-forming material.

(57) A process for forming an image is disclosed comprising subjecting an image-forming material comprising a first substrate, a photosensitive layer comprising a dye and/or pigment and a photopolymerizable compound and formed on one surface of the substrate, and a second substrate formed on the photosensitive layer, to the steps of:
(a) imagewise exposing the image-forming material to harden an exposed portion thereof,
(b) separating the second substrate such that the whole of the exposed portion and part of a nonexposed portion is separated from the rest of the image-forming material together with the second substrate, and
(c) contacting the part of the nonexposed portion remaining on the first substrate with an image receptor under pressure, to transfer the said nonexposed portion to the image receptor. An image-forming material suitable for use in the process is also disclosed.

EP 0 413 863 A1

## IMAGE-FORMING PROCESS AND IMAGE-FORMING MATERIAL

### FIELD OF THE INVENTION

The present invention relates to a process and material for forming an image. More specifically, it relates to a process and material for forming a transferred image very similar to a printed image and usable as a color proofing surprint prepress proof.

### PRIOR ART OF THE INVENTION

In the field of printing industry, it is known that proof printing or prepress proof is used in order to see the finish, color tone, etc., of a final printed matter in advance of actual printing.

The prepress proof has an advantage that the finish of a final printed matter can be estimated without using any printing ink, and an overlay process, surprint process, etc., are selectively used depending upon the final quality of an iamge to be printed, plate-making and various purposes in printing process.

The overlay process uses films comprising a clear base film and a photosensitive layer containing a different coloring material corresponding to a color separation mask, and proofing is carried out by bringing each of these films into intimate contact with a mask, effecting exposure and development, and overlaying these films.

The surprint process differs from the overlay process and can give a hard copy. Hence, it has high utility value. For example, as described in U. S. Patents 3060023, 3060024 and 3060025, images on several photopolymer sensitive layers are consecutively laminated on a single substrate to form an iamge consisting of different colors.

Further, there is a process for forming a prepress proof, which is usable in both the overlay process and the surprint process, as is described in Japanese Laid-Open Patent Publications Nos. 97410/1984 and 188537/1986. This process has an advantage that it can be selectively used depending upon ends in use. That is, characters, etc., can be simply checked according only to an overlay method, and when a hard copy is necessary to check a subtle colored portion such as a picture and pattern, the hard copy can be obtained by transferring an image on a prepress proof sheet to an image receptor. However, this process has a defect that since it requires a development step using an organic solvent and hence brings a working environment into bad condition.

Japanese Laid-Open Patent Publication No. 79032/1979 discloses a process for forming a relief image which comprises imagewise exposing a photosensitive, image-forming material consisting of a substrate and a thermoplastic photosenstive composition formed thereon, heating the photosensitive, image-forming material while a carrier for separation development, which has a plastic layer to exhibit adherence to the photosensitive composition under heat, is in intimate contact, and then separating the carrier. However, if an relief image obtained according to this process is used for a surprint prepress proof, the photosensitive composition in the entire thickness is transferred. The defect is therefore a difficulty to obtain an image being similar to an actual printed iamge. Since it has too high gloss.

The processes for the preparation of prepress proofs according to prior art include a substantial development step as explained above, and their preparation steps are complicated. The textures of obtained images differ from that of an actual printed image. It has been hence recognized that images obtained according to prior art processes differ from an actual printed image with regard to quality, although they have been often used to check printing steps from plate-making to printing.

The present inventors have found that an image, which is comparatively similar to an actual printed image and has excellent texture, can be obtained by a process which comprises imagewise exposing an image-forming material consisting of a clear substrate and a photosensitive layer containing a dye and/or pigment on the substrate, and introducing the exposed image-forming material and an image receptor into a nip portion between rolls to transfer part of the photosensitive layer along its thickness due to a cohesive failure of the photosensitive layer (see Japanese Patent Application No. 17464/88).

Even in the above process, however, a nontransfer portion (exposed portion) and a transfer portion (nonexposed portion) are existent on the same plane of a sheet, and when the transfer portion is transferred onto the image receptor under pressure, the nontransfer portion works to prevent the spreading of the transfer portion. In actual printing, an ink exhibits not only an inner division but also a phenomenon of so-called mechanical dot gain in which a transferred ink spreads its area under pressure. In the above process, the cohesive failure of the photosensitive layer corresponding to the inner division of the ink takes place, but any phenomenon of mechanical dot gain does not occur. Hence, there is a problem that a prepress proof obtained by the above process has a different gradation than an actual printed image, even though a half tone positive image is dot-reproduced.

## SUMMARY OF THE INVENTION

It is an object of the present invention to provide a process and material for forming an image, which exhibit phenomena corresponding to mechanical dot gain and inner division of an ink.

It is another object of the present invention to provide a process and material for forming an image having a texture equivalent to that of an actual printed image.

It is yet another object of the present invention to provide a process and material for forming an image, which are suitable for use in a surprint process and which give a surprint final image facing the same direction as that of an actual printed image without using any intermediate image receptor.

It is further another object of the present invention to provide a process and material for forming an image, which give an image equivalent to a proof printed image printed by using a proof printing machine, and which hence omit the use of a proof printing machine.

The present invention provides a process for forming an image, which comprises subjecting an image-forming material consisting of a first substrate, a photosensitive layer formed on one surface of the substrate and containing a dye and/or pigment and a photopolymerizable compound, and a second substrate formed on the photosensitive layer,

to the following steps:

(a) a step of imagewise exposing the image-forming material to harden an exposed portion,

(b) a step of separating the second substrate thereby to separate the whole of the exposed portion and part, along the thickness, of a nonexposed portion from the image-forming material together with the second substrate, and

(c) a step of bringing part, along the thickness, of the nonexposed portion remaining on the first substrate into contact with an image receptor under pressure to transfer same.

The present invention further provides an image-forming material comprising a first substrate, a photosensitive layer formed on one surface of the substrate and containing a dye and/or pigment and a photopolymerizable compound, and a second substrate formed on the photosensitive layer, wherein, when the second substrate is separated from said material, adhesion strength between an exposed portion of the photosensitive layer and the first substrate is smaller than adhesion strength between said exposed portion and the second substrate, and cohesive strength of a nonexposed portion of the photosensitive layer is smaller than adhesion strength between said nonexposed portion and each of the first and second substrates.

## DETAILED DESCRIPTION OF THE INVENTION

It has been surprising that an image very similar to an actual printed image can be obtained in the present invention by simply reproducing the phenomenon of mechanical dot gain taking place in an actual printing in addition to cohesive failure corresponding to cohesive failure of a printing ink.

That is, the present invention provides a process and material for forming an image, in which a color proof having an equivalent texture to that of a printed image can be obtained simply, speedily and smoothly according to a surprint process. The process and material of the present invention is also applicable to an overlay process. Namely, the present invention provides a process and material for forming an image, in which an image having nearly identical texture to that of a printed image printed by using a printing machine can be obtained, and further, a color proof stable in quality can be obtained by a dry development process using no developing liquid, i.e. by separation development.

The present invention provides an iamge very similar to actual printed matter, since it has mechanical dot gain seen in actual printed matter and cohesive failure of a photosensitive layer corresponding to inner division of a printing ink. That is, in the present invention, it is possible to transfer an image directly to an ink receptor used in printing using a printing machine such as art paper, and that the photosensitive layer is transferred in the same state as in printing using a printing machine. Further, fine iamges can be also transferred smoothly.

In the present invention, preferable is a process for forming an image in which image exposure is carried out from the first substrate side (the first substrate is often transparent). The use of this process remarkably improves positional relations of an iamge, e.g. facing direction of an iamge, etc., and obviates any special intermediate image receptor to correct the facing direction of an image.

In addition, in the present invention, the first substrate refers to that which is separated after brought into contact with an image receptor under pressure.

Suitably usable as the first substrate are materials which are stable against heat, chemcials and lights, and which are permeable to active rays. Examples of these materials include films or sheets of cellulose acetate, polystyrene, vinyl chloride, polyethylene terephthalate, polycarbonate, polypropylene, etc. In particular, a polyethylene terephthalate film or sheet is preferably usable in terms of transparency, thermal stability and dimensional stability.

The second substrate is also similarly selected from materials which are stable against heat, lights and chemicals. Since the photosensitive layer which is optically hardened has to shift from the first substrate to the second substrate, adhesion strength between the second substrate and the exposed portion has to be larger than adhesion strength between the first substrate and the exposed portion. Materials for the first and second substrates have to be selected from this viewpoint, and the selection will be explained further in detail below.

First, in adhesion strength between the photosensitive layer and the substrates, the exposed portion (hardened portion) has a relationship wherein it has smaller adhesion strength to the first substrate than to the second substrate, and the nonexposed portion has a relationship wherein adhesion strength to the second substrate $\geq$ adhesion strength to the first substrate > cohesive strength of the photosensitive layer.

The above relationships can be obtained (1) by using first and second substrates which are the same in quality, applying a photosensitive layer liquid onto the second substrate, drying and then laminating it to the first substrate, or using a multilayered photosensitive layer in which a photosensitive layer having lower adhesion strength is formed on the first substrate side and a photosensitive layer having higher adhesion strength is formed on the second substrate side, (2) by using first and second substrate which are the same in quality, and treating them to differentiate their adhesion strength, e.g. leaving the first substrate untreated and subjecting the second substrate to adhesion-easing treatment such as corona discharge treatment, or (3) by using first and second substrates which are different in quality, e.g. untreated polyethylene terephthalate as the first substrate and a metallic foil as the second substrate.

In addition to the above corona discharge treatment, the adhesion strength of the second substrate to the photosensitive layer may be increased by forming a coated layer on the second substrate to improve its wetting, by applying a releasing agent, or the like. The corona discharge treatment is the most preferable from the viewpoint that it is less expensive but effective.

Further, unlike the first substrate, the second substrate is not required to be permeable to active rays, and the use of a substrate having at least one highly reflective metal layer can overcome narrowness of exposure latitude seen in case of a photosensitive layer which absorbs a large amount of active rays.

Metals used in a metal layer formed in the second substrate are aluminum, nickel, gold, silver, etc., however, no limitation is imposed on these metals if they are reflective to active rays. Practically, aluminum is preferably usable.

The metal layer is usually formed into a composite with a plastic film. However, for example, an aluminum foil may be used alone without any plastic film.

The second substrate is practically formed by providing an aluminum deposition layer or sputtered layer onto a plastic film such as polyethylene film, polyethylene terephthalate film, polypropylene film, triacetate film, or the like. A film prepared by laminating an aluminum foil and a plastic film is also effectively usable.

The photosensitive layer of the present invention comprises:

(a) a photopolymerizable compound and coloring agent, or

(b) a photopolymerizable compound, thermoplastic resin, a coloring agent, etc.

In general, the photosensitive layer of the present invention may further contain a photopolymerization initiator, photopolymerization promoter, thermal polymerization inhibitor, resin plasticizer, pigment dispersant, etc.

The photopolymerizable compound is at least one selected from a monomer, oligomer and prepolymer.

No special limitation being imposed on the photopolymerizable compound, compounds which can plasticize a thermoplastic resin at ordinary temperature are preferably usable.

The photosensitive layer uses a photopolymerizable compound such that a mixture of the photopolymerizable compound with a dye and/or pigment can be hardened by exposure.

In the present invention, cohesive failure is made to take place twice in the nonexposed portion, i.e. when the second substrate is separated from the image-forming material and when the nonexposed portion remaining on the first substrate is transferred to an image receptor. For this reason, the thickness of the photosensitive layer is required to be twice as large as that when cohesive failure takes place once. In general, a photosensitive layer containing yellow, magenta, or the like, has high sensitivity and a wide exposure latitude even if the incorporation amount of the photopolymerization initiator is small, since it has a low absorptivity of active rays. In this case, therefore, the thickness of the photosensitive layer can be made larger without any special problem. When a photosensitive layer contains cyan, black, or the like, it has a high absorptivity of active rays, and hence it has a narrow exposure latitude even if the incorporation amount of the photopolymerization initiator is large. In this case, there is a risk of occurence of problems that the mere increase of the photosensitive layer thickness leads to an increase of exposure time due to a decrease of the sensitivity and the proper exposure latitude is narrowed. For this reason, it is necessary to design these photosensitive layers such that each of them sandwitched between the first and second substrates is fully hardened by means of a predetermined exposure and that the reflection density of an image to be formed on an image receptor such as paper, etc., comes under a predetermined value. For example, the photosensitive layer may be designed as a multilayered photosensitive layer in which the major portion of layers adhered to the second substrate, when the second substrate is separated, consists of layers containing no coloring agent and having high sensitivity and wide exposure latitude, and the major portion of layers adhered to the first substrate, when the first substrate is then separated from an image receptor, consists of layers containing no coloring agent and having high sensitivity and wide exposure latitude. Then, the above-stated problems can be solved.

The proper cohesive strength of the photosensitive layer of the present invention can be variously selected depending upon kinds and proportions of photopolymerizable compounds and dyes and/or pigments used in the photosensitive layers. Further, it has to be changed according to kinds of an image receptor and the substrates.

Preferably usable as the photopolymerizable compound in this invention are ethylenically unsaturated compounds, and examples thereof include low-molecular-weight photopolymerizable compounds such as (meth)acrylic acid, methyl(meth)acrylate, butyl(meth)acrylate, cyclohexyl(meth)acrylate, dimethylaminoethyl-(meth)acrylate, benzyl(meth)acrylate, carbitol(meth)acrylate, 2-ethylhexyl(meth)acrylate, lauryl(meth)acrylate, 2-hydroxyethyl(meth)acrylate, 2-hydroxypropyl(meth)acrylate, glycidyl(meth)acrylate, (meth)acrylamide, N-methylol(meth)acrylamide, styrene, acrylonitrile, N-vinyl pyrolidone, ethyleneglycoldi(meth)acrylate, diethyleneglycoldi(meth)acrylate, triethyleneglycoldi(meth)acrylate, polyethyleneglycoldi(meth)acrylate, polypropyleneglycoldi(meth)acrylate, butyleneglycoldi(meth)acrylate, neopentylglycoldi(meth)acrylate, 1,4-butanedioldi(meth)acrylate, 1,6-hexanedioldi(meth)acrylate, pentaerythritoldi(meth)acrylate, pentaerythritoltri-(meth)acrylate, trimethylolpropanetri(meth)acrylate, dipentaerythritolhexa(meth)acrylate, phenoxyethyl(meth)-acrylate, nonylphenoxy(meth)acrylate, tetrahydrofurfuryloxy(meth)acrylate, caprolactone-modified tetrahydrofurfuryl(meth)acrylate, ethylene oxide (EO)-modified(meth)acrylate, phenoxydiethyleneglycol (meth)acrylate, EO-modified phthalic acid (meth)acrylate, (meth)acrylate of alkylen oxide-added phenol, caprolactone-modified hydroxypivalic acid neopentylglycol-di(meth)acrylate, dicyclopentanyldi(meth)-acrylate, etc., or high-molecular-weight photopolymerizable compounds such as epoxy(meth)acrylate, urethane(meth)acrylate, polyester(meth)acrylate, alkyd(meth)acrylate, modified (meth)acrylate of petroleum resin, unsaturated polyester, etc. These compounds may be used alone or in combination.

The thermoplastic resin (organic polymer binder) usable in this invention is a polymer which is thermoplastic, excellent in compatibility with a photopolymerizable compound and substantially devoid of photopolymerization properties. Examples of the thermoplastic resin include polyvinyl chloride, poly(meth)-acrylic acid, poly(meth)acrylate ester, polyvinyl ether, polyvinyl acetal, urethane resin, epoxy resin, polyamide, polyester, vinylidene chloride-acrylonitrile copolymer, vinylidene chloride-methacrylate copolymer, vinylidene chloride-vinyl acetate copolymer, ethylene-vinyl acetate copolymer, cellulose derivative (e.g. methylcellulose, ethylcellulose and cellulose acetate), polyolefin (e.g. chlorinated polyethylene), synthetic rubber such as butadiene-acrylonitrile copolymer, diallylphthalate resin (e.g. diallylisophthalate polymer, diallylorthophthalate polymer and hydrogenated products of these), etc.

It is also possible to obtain the desired physical property by adding some other polymer than the above thermoplastic substances. For example, adhesion to a substrate and adhesion to a receptor in transfer can be improved. Examples of the suitable polymer substance that is not thermoplastic include phenol resin, melamine or benzoguanamine-formaldehyde resin, urethane resin, etc. Beside these, the photosensitive layer may contain, as a component, a small amount of a filler, examples of which include silica, mica, bentonite, etc., and the suitable amount of the filler depends upon a quality required.

The photopolymerization initiator having a small absorptivity in the visible ray region is preferable. Examples of the initiator include benzophenone, 4,4-bis(diethylamino)benzophenone, 4-methoxy-4-dimethylaminobenzophenone, 2-ethylanthraquinone, phenanthraquinone, benzoin, benzoinmethyl ether, benzoinphenyl ether, isobutylbenzoin ether, benzoinethyl ether, isopropylbenzoin ether, 2,2-diethoxyacetophenone, 2-hydroxy-2-methyl-propiophenone, 4'-isopropyl-2-hydroxy-2-methylpropiophenone, p-tert-butyltrichloroacetophenone, Michler's ketone, benzyldimethylketal, 2,2-dimethoxy-2-phenylacetophenone, hydroxycyclohexylphenyl ketone, benzophenone, azobisisobutylnitrile, 2-chlorothioxanthone, 2-methylthioxanthone, 2-ethylthioxanthone, 2-isopropylthioxanthone, etc. These addition polymerization initiators may be used alone or in combination. When two or more initiators are used in combination, mututal influences on free radicals to be generated by individual light absorptions should be taken into consideration. Further, various sensitizers may be added in order to improve the rate of addition polymerization.

As a thermalpolymerization inhibitor, there may be used p-methoxyphenol, hydroquinone, t-butylcatechol, pyrogallol, pyridine, aryl phosphite, etc.

The film thickness of the photosensitive layer may be about 0.5 to 5 $\mu$m. Although the suitable amount of the photopolymerizable compound to be applied varies according to a dye and/or pigment to be contained, the suitable amount is from 0.5 g/m² to 10 g/m². In this invention, the photosensitive layer is formed on the substrate by using a wire-wound bar coater, gravure coater, etc.

Besides the above thermoplastic substances, some other effective substances may be cited. However, in view of a combination with a suitable ethylenically unsaturated compound, polyacrylate-type high-molecular-weight substances and a diallylisophthalate polymer are suitable. The suitable ratio between the thermoplastic substance and ethylenically unsaturated compound varies depending upon what materials are used as said substance and compound. In general, the weight ratio between the thermoplastic substance and ethylenically unsaturated compound is between 40 : 60 and 90 : 10. When the amount of the ethylenically unsaturated compound is larger than the above upper limit, the photosensitive layer has fluidity and is likely to become nonuniform while the image-forming material is stored, and the photosensitive layer tends to seep out from the peripheral portion of the image-forming material. A small amount of a thermal polymerization inhibitor may further be added to prevent a dark reaction from taking place with the passage of time.

As a dye and/or pigment to be contained in the photosensitive layer, conventionally known dyes and pigments may be used. In general, dyes and/or pigments of four colors, yellow, magenta, cyan and black, are necessary, and in addition, a metal powder, white pigment, fluorescent pigment, etc., may be also used. As for color proof for which yellow, magenta, cyan and black are used, any pigment or dye agreeing with the hues thereof may be selected.

The following are some examples of kown dyes and pigments of azo type, phthalocyanine type, quinacridon type, anthraquinone type, indigo type, methine type, etc., and inorganic pigments etc, which are suitably used in the present invention.: Lionol Yellow GRO (C. 121090), No. 1201 Lionol Yellow, No.1206 Lionol Yellow, Lionol Yellow 1208, No.1305 Lionol Yellow (C. 121100), No.1306 Lionol Yellow, No,1307 Lionol Yellow, Lionol Yellow FG1310, Lionol Yellow FGN-T (C. 121105), No.7100 Lionol Yellow (C. 121096), Lionol Yellow-NBR (C. 121108), Brilliant Carmine 6BA (C. 115850 : 1), Lionol Red 6B4201, Lionol Red 7B4401, Brilliant Carmine 8BA, Lionol Blue FG7330 (C. 174160), Lionol Blue FG7351, Lionol Blue GX-1 (the above items are all manufactured by Toyo Ink Manufacturing Co., Ltd.), Mitsubishi Carbon Black MA-7, Mitsubishi Carbon Black MA-100, etc. As a colorant, these dyes and pigments may be used alone or in combination.

These dyes and pigments can be easily incorporated into the photosensitive layer by suitable means known to one skilled in the art.

The suitable amount of the dye and/or pigment to be incorporated into the photosensitive layer is 5 to 50 % by weight based on the entire solids. If it is less than 5 % by weight, too large an amount of a coating (film) is required to obtain a necessary color density, and a transferred image tends to be poor. If it is more than 50 % by weight, active rays are not sufficiently trasnmitted to cause stain.

The following will explain each of the steps using the present invention as an image-forming material, e.g. for color proofing.

(1) Holes for register pins are made in a color-separation image mask and an image-forming material. Further, if a paper, etc., are used as an image receptor, holes for regiser pins are also made in the image receptor.

(2) An image exposure was carried out. That is, the photosensitive layer is imagewise exposed sufficiently through a color separation mask image to harden the image-forming material by using active ray, e.g. ultra violet ray.

(3) Then, the image-forming material is introduced, e.g. into a nip portion between heating rolls to heat it to a suitable temperature, and thereafter, an exposed portion and part, along the thickness, of a nonexposed portion are separated from the image-forming material by separating a second substrate. A nonexposed portion (which is an image) remaining on a first substrate is arranged such that it faces an image receptor but is substantially not in contact with the image receptor, and then introduced into a nip portion between rolls to transfer the image to the image receptor. The first substrate is separated from the image receptor immediately after these two members have passed the nip portion.

In general, the transfer is carried out under heat as required. The separation of these two members by holding one end of the substrate leaves 1/2 or a proper proportion, along the thickness, of the image formed on the photosensitive layer on the image receptor owing to a predetermined internal division strength, i.e. a transferred image is formed on the receptor.

(4) The transferred image is post-exposed in order to secure the firm adhesion thereof and dissipate the viscous property on the transferred image surface.

The above steps 1 to 4 are repeated, for example, 4 times (yellow, magenta, cyan, black) to obtain a reproduced image of the four colors for color proofing.

As examples of the above receptor, there are art papers, coat papers, etc., which are materials for use generally in proof printing. However, these examples shall not limit this invention.

The process and material of the present invention are applicable to not only the formation of an image on an image receptor by heating, contact and transfer in a nip between rolls but also an image-formation using an apparatus consisting of rolls and a flat bed.

The following will explain the present invention using an apparatus having at least two rolls.

The contact and transfer between the photosensitive layer and the image receptor are usually carried out under pressure and heat. It may also be carried out only under pressure. In addition, when the heating is employed, it is preferable that the heating is not so strong as to shrink and expand the image-forming material. For example, the roll(s) has a surface temperature of between $50^{\circ}$ C and $150^{\circ}$ C, preferably between $70^{\circ}$ C and $110^{\circ}$ C. Then, the heating with such a roll has a good effect on improvement in the transfer speed and reproduction accuracy of fine images. That is, the transfer can be carried out without causing problems of mottling, picking, etc.

Further, there may be a thermal difference between the surface of one roll and the surface of the other. For example, one roll may be heated and the other roll may be cooled.

As a device to carry out the transfer between rolls, a conventional laminater, etc., may be applied to carry out the transfer and separation of this invention.

The most simplest constitution of only two rolls may be sufficient for the transfer between rolls. In this case, for example, the heating procedure is easy, the space for the device is small, and the preperation for operation is simple. Further, an exposure device may be incorporated in addition to the two rolls, whereby the operation from the exposure to the transfer can be carried out in series.

Adjustment of the pressure between rolls is easy, since there are only two rollers, and the pressure can be also adjusted simply to any neccessary pressure. Further, there is an advantage that the uniform pressurization makes the transfer operation easy and requires no skilled worker to obtain several sheets of an image uniformly. This advantage meets an actual demand for proof-printing of a plurality of sheets of an image based on one original image, and is useful.

The present invention obviates complicate procedures of development using a development liquid, required of conventional methods, and makes it possible to reproduce, by simple procedures, images having a texture very similar to printed matter on an image receptor such as paper, etc.

According to the present invention, there is provided a process and material for forming an image, which make it possible to provide an image very similar to an actual printed image due to mechanical dot gain seen in actual printed matter and internal division of a photosensitive layer corresponding to the internal division of a printing ink.

According to the present invention, there is provided a process and material for forming an image having a texture equivalent to that of an actual printed image.

According to the present invention, there is provided a process and material for forming an image, which are suitable for use in a surprint process and which give a surprint final image facing the same direction as that of an actual printed image without using any intermediate image receptor.

Further, according to the present invention, there is provided a process and material for forming an image, which give an image equivalent to a proof printed image printed by using a proof printing machine, and which hence omit the use of a proof printing machine.

The following Examples illustrate this invention, in which "part" stands for "part by weight" and "%" stands for "% by weight".

EXAMPLE 1

A liquid for a photosensitive layer having the following formulation was prepared.

Diallylisophthalate prepolymer, Daiso Isodap Mn45000 (trade name, made by Osaka Soda Co., Ltd.,): 18.40 parts

Dipentaerythritolhexaacrylate, DPHA (trade name, made by Nippon Kayaku Co., Ltd.): 9.91 parts

Photopolymerization initiator, benzophenone: 0.5 part

4,4 bis-Diethylaminobenzophenone, EAB, (trade name, made by Hodogaya Chemical Co., Ltd.): 0.17 part

Hydroquinone: 0.001 part

Carmine 7BFG4412 (trade name, made by Toyo Ink Manufacturing Co., Ltd: 5.0 parts

Toluene: 38.0 parts

Methyl ethyl ketone: 40.0 parts

The above liquid for a photosensitive layer was coated on the corona discharge-treated surface of a second substrate of a biaxially stretched polyethylene terephthalate film (thickness = 50 μm) such that a dried coating thickness was 4.8 μm, and a first substrate of a polyethylene terephthalate film (thickness = 12 μm, not treated with corona discharge) was attached onto the coated surface to prepare an image-forming material.

The image-forming material is imagewise exposed after the emulsion surface of a positive image film having dot percents of 0.2, 5, 50, 95, 98 and 100 % (trade name: Startarget, made by E. I. du Pont de Nemours and Company) was brought into contact with the first substrate side, and the image-forming material was directed through a heated laminator. Immediately after it passed the laminator, the second substrate was separated to give an image having only a nonexposed portion on the first substrate.

Then, the image was transferred to an art paper as an image receptor under pressure while bringing the art paper into contact with the photosensitive layer on the first substrate in the nip portion of rolls. These two members were separated immediately after they passed the nip portion, and the art paper was post-exposed to give an image of the same finish as that of actual printed matter as shown in Table 1. In addition, the exposure conditions under ultraviolet ray and the laminator conditions were as follows.

Exposure Conditions (UV apparatus, ORCHMW-201KB, made by Orch Seisakusho):

Image exposure - 100 mJ/cm$^2$
Post-exposure - 500 mJ/cm$^2$

Laminator Conditions:

Upper roll - a rubber roll having a diameter of 150 mm, a temeperature of 50 °C, a width of 300 mm and a Shore hardness A of 70.

Lower roll - a chromium-plated metal roll having a diameter of 150 mm, a temperature of 100 °C and a width of 300 mm.

Contact width - 10 mm

Feed rate - 50 mm/minute

Nip pressure - A load of 28.3 kg was applied to each side of shaft of the upper roll by using an air cylinder.

## COMPARATIVE EXAMPLE 1

Example 1 was repeated except that a polyethylene film was used as a second substrate, no laminator was used after an image-forming material was imagewise exposed, and the polyethylene film was removed. A photosensitive layer remained on the first substrate as a whole. An image was transferred from the first substrate to an art paper to show dot percents as shown in Table 1.

## REFERENTIAL EXAMPLE 1

A press plate was prepared from the positive image film used in Example 1, and an image was printed by using the press plate. The printed image had dot percents as shown in Table 1.

TABLE 1

| (Results of measurements of dot percents) | | | | | | | |
|---|---|---|---|---|---|---|---|
| | Dot percent | | | | | | |
| Positive film | 0 | 2 | 5 | 50 | 95 | 98 | 100 |
| Example 1 | 0 | 3 | 7.8 | 59.9 | 97.0 | 99.8 | 100 |
| Comparative Example 1 | 0 | 1.8 | 4.7 | 48.0 | 93.0 | 96.5 | 100 |
| Referenctial Example 1 | 0 | 0 | 8.2 | 62.0 | 99.2 | 100 | 100 |
| (The dot percents were measured by using a dot meter, model Beuvac III, made by Toyo Ink Manufacturing Co., Ltd.) | | | | | | | |

EXAMPLE 2

By using carbonblack MA-7 (trade name, made by Mitsubishi Chemical Co., Ltd.) in place of the Carmine 7BFG4412 used in Example 1, a liquid for a photosensitive layer having the following formulation was prepared.

Diallylisophthalate prepolymer, Daiso Isodap Mn45000 (trade name, made by Osaka Soda Co., Ltd.,): 18.40 parts

Dipentaerythritolhexaacrylate, DPHA (trade name, made by Nippon Kayaku Co., Ltd.): 9.91 parts

Benzophenone (made by Daiichi Kasei): 2.25 parts

4,4 bis-Diethylaminobenzophenone, EAB, (trade name, made by Hodogaya Chemical Co., Ltd.): 0.75 part

MA-7: 3.0 parts

R-52 (made by Hoechst Japan): 1.0 part

Methyl ethyl ketone: 40.0 parts

Toluene: 10.0 parts

Xylene: 10.3 parts

Further, a liquid for a clear photosensitive layer having the following formulation (without pigment and dye) was prepared.

Diallylisophthalate prepolymer, Daiso Isodap Mn45000 (trade name, made by Osaka Soda Co., Ltd.,): 19.8 parts

Dipentaerythritolhexaacrylate, DPHA (trade name, made by Nippon Kayaku Co., Ltd.): 8.5 parts

Benzophenone (made by Daiichi Kasei) : 0.5 part

4,4 bis-Diethylaminobenzophenone, EAB, (trade name, made by Hodogaya Chemical Co., Ltd.): 0.2 part

Methyl ethyl ketone: 40.0 parts

Toluene: 10.0 parts

Xylene: 10.3 parts

The liquid for a black photosensitive layer was coated on a biaxially stretched polyethylene terephthalate film (thickness = 12 $\mu$m, not treated with corona discharge) as a first substrate such that the dried film thickness was 2.4 $\mu$m.

On the other hand, the liquid for a clear photosensitive layer was coated on an aluminum (thickness = 800Å)-deposited polyethylene terephthalate film (thickness = 25 $\mu$m) as a second substrate such that the dried film thickness was 2.4 $\mu$m.

These two films were laminated such that their photosensitive layers were in contact in the nip portion of rolls to prepare an image-forming material.

The image-forming material was imagewise exposed in the same way as in Example 1, and the second substrate was separated from the first substrate immediately after they passed a heated laminator, to form an image having only a non-hardened photosensitive layers on the first substrate.

Then, the image was transferred to an art paper as an image receptor and post-exposed in the same way as in Example 1 to give a transferred image exhibiting the same dot percents as in Example 1. Its reflection density was nearly identical with that of actual printed matter.

EXAMPLE 3

A liquid for a photosensitive layer having the following formulation was prepared.

Diallylisophthalate prepolymer, Daiso Isodap Mn45000 (trade name, made by Osaka Soda Co., Ltd.,): 18.40 parts

Dipentaerythritolhexaacrylate, DPHA (trade name, made by Nippon Kayaku Co., Ltd.): 9.91 parts

Benzophenone (made by Daiichi Kasei): 1.5 parts

4,4 bis-Diethylaminobenzophenone, EAB, (trade name, made by Hodogaya Chemical Co., Ltd.): 0.5 part

Lionol Blue FG7330 (trade name, made by Toyo Ink Manufacturing Co., Ltd.): 4.0 parts

Methyl ethyl ketone: 40.0 parts

Toluene: 10.0 parts

Xylene: 10.3 parts

The above liquid for a photosensitive layer was coated on a second substrate prepared by depositing aluminum (thickness = 800 Å)-on polyethylene terephthalate film (thickness = 25 $\mu$m), such that the dried film thickness was 4.8 $\mu$m, and then a first substrate of a polyethylene terephthalate film (thickness = 12 $\mu$m, not treated with corona discharge) was applied onto the coated surface to prepare a cyan color image-forming material.

Then, the procedure of Example 1 for the preparation of a liquid for a photosensitive layer was repeated except that Lionol Yellow FG1310 (trade name, made by Toyo Ink Manufacuring Co., Ltd.) was used in place of Carmine 7BFG4412, and the procedures of Example 1 for coating and drying were repeated to prepare a yellow color image-forming material. These image-forming materials were iamgewise exposed by using positive image film (Startarget, trade name, made by E. I. du Pont Nemours and Company), and formed images were transferred to art papers in the same way as in Example 1.

The dot percents of each of the colors were nearly identical with those in Example 1.

Each of the image-forming materials for cyan and yellow obtained in Example 3, the image-forming material for magenta obtained in Example 1 and the image-forming material for black obtained in Exmample 2 was registered with a corresponding color separation positive film by using register pings, and imagewise exposed in the same way as in Example 1. And images on these exposed image-forming materials were respectively transferred to the same art paper by directing them into the nip portion between rolls under pressure in order of black, cyan, magenta and yellow. Immediately after they passed the nip portion each time, the transferred image was post-exposed.

The color image produced by the above procedures had a texture very similar to ordinary printed matter.

Further, by using the same original image film, the above image-forming procedure was repeated four times to show that the formed four images were identical and indistinguishable.

EXAMPLE 4

A liquid for a photosensitive layer having the following formulation was prepared.

Chlorinated polyethylene LT-507 (made by Sanyo-Kokusaku Pulp Co., Ltd.): 20 parts

Dipentaerythritolhexaacrylate, DPHA (trade name, made by Nippon Kayaku Co., Ltd.): 20 parts

Benzophenone: 0.75 part

4,4 bis-Diethylaminobenzophenone: 0.25 part

Carmine 7BFG4412: 7.06 parts

Toluene: 110.00 parts

The above liquid for a photosensitive layer was coated on a second substrate of a surface-treated, biaxially stretched polyethylene film Melinex 542 (thickness = 50 $\mu$m, made by Imperical Chemical Inc.) such that the dried film thickness was 4.8 $\mu$m, and then a first substrate of a polyethyleneterephthalate film (thickness = 12 $\mu$m, not treated with corona discharge) was applied onto the coated surface to prepare an image-forming material.

The image-forming material was imagewise exposed by using a positive image film in the same way as in Example 1, and the second substrate was separated immediately after it passed a heated laminator, to form an image of only a nonexposed portion on the first substrate.

The image was then transferred under pressure to an art paper as an image receptor in the same way as in Example 1. The first substrate was separated immediately after the first substrate and the art paper passed a nip portion, and the formed image was post-exposed to give the same results as in Example 1.

## Claims

1. A process for forming an image, which comprises subjecting an image-forming material comprising a first substrate, a photosensitive layer comprising a dye and/or pigment and a photopolymerizable compound and formed on one surface of the substrate, and a second substrate formed on the photosensitive layer, to the steps of:

(a) imagewise exposing the image-forming material to harden an exposed portion thereof,

(b) separating the second substrate such that the whole of the exposed portion and part of a nonexposed portion is separated from the rest of the image-forming material together with the second substrate, and

(c) contacting the part of the nonexposed portion remaining on the first substrate with an image receptor, under pressure, to transfer the said nonexposed portion to the image receptor.

2. A process according to claim 1 wherein the step (b) is carried out by warming the photosensitive layer up to a temperature at which the nonexposed portion of the photosensitive layer undergoes cohesive failure such that the cohesive force within the photosensitive layer is smaller than the adhesive forces between the first substrate and the photosensitive layer and between the second substrate and the photosensitive layer.

3. A process according to claim 1 wherein the step (c) is carried out by warming the photosensitive layer up to a temperature at which the nonexposed portion of the photosensitive layer undergoes cohesive failure such that the cohesive force within the photosensitive layer is smaller than the adhesive force between the first substrate and the photosensitive layer.

4. A process according to any one of the preceding claims wherein the second substrate has a surface treated so as to enhance the adhesive force between the substrate and the exposed portion of the photosensitive layer.

5. A process according to any one of the preceding claims wherein the image-forming material comprises two or more photosensitive layers, at least two of which have different adhesion properties such that the adhesive force between the exposed portion of the photosensitive layer on the first substrate side and the first substrate is less than the adhesive force between the exposed portion of the photosensitive layer on the second substrate and the second substrate.

6. A process according to any one of the preceding claims wherein the photosensitive layer, or at least one of the photosensitive layers, comprises from 5 to 50% by weight of a dye and/or pigment.

7. A process according to any of the preceding claims wherein the photosensitive layer undergoes cohesive failure such that the cohesive force within the layer is less than the adhesive forces between the first substrate and the nonexposed portion of the photosensitive layer and between the second substrate and the nonexposed portion of the photosensitive layer.

8. A process according to any one of the preceding claims wherein the second substrate has a metallic surface which is in contact with the photosensitive layer.

9. An image-forming material suitable for use in the process as claimed in any one of claims 1 to 8, which comprises a first substrate, a photosensitive layer comprising a dye and/or pigment and a photopolymerizable compound and formed on one surface of the substrate, and a second substrate formed on the photosensitive layer.

10. A process for producing an image-forming material as claimed in claim 9 comprising coating the photosensitive layer in liquid form on the second substrate, drying the coating and disposing the first substrate on the photosensitive layer.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | DE-A-2149056 (E.I.DU PONT DE NEMOURS AND CO.)<br>* the whole document * | 1-10 | G03F3/10<br>G03F7/34 |
| X | US-A-3754920 (A.D.KUCHTA)<br>* the whole document * | 1-10 | |
| X | DE-A-3800768 (TOYO INK MFG.CO.)<br>* the whole document * | 2, 3 | |
| X | EP-A-25088 (E.I.DU PONT DE NEMOURS AND CO.)<br>* the whole document * | 5 | |
| X | FR-A-2001913 (E.I.DU PONT DE NEMOURS AND CO.)<br>* the whole document * | 5 | |
| X | EP-A-323191 (TOYO INK MFG. CO.)<br>* the whole document * | 5 | |
| A | GB-A-1090663 (E.I.DU PONT DE NEMOURS AND CO.)<br>* the whole document * | 1-10 | |
| A | US-A-3481736 (R.B.RUFF)<br>* the whole document * | 1-10 | **TECHNICAL FIELDS SEARCHED (Int. Cl.5 )**<br><br>G03F |

The present search report has been drawn up for all claims

| Place of search | Date of completion of the search | Examiner |
|---|---|---|
| THE HAGUE | 27 APRIL 1990 | RASSCHAERT A. |

EPO FORM 1503 03.82 (P0401)